# FASCICULE DE BREVET EUROPEEN

(11) **EP 4 350 438 B1**
(45) Date de publication et mention de la délivrance du brevet: **02.12.2026**
(21) Numéro de dépôt: 23202044.6
(22) Date de dépôt: 06.10.2023
(51) Int. Cl.: G03F 7/00, G03F 7/40, C25D 5/02, C23C 14/04, C23C 14/00, C23C 14/14, C23C 14/24, C23C 18/16, C25D 1/00

(54) **PROCÉDÉ DE FABRICATION D'UN MOULE POUR FORMER UNE PIÈCE MÉTALLIQUE PAR CROISSANCE MÉTALLIQUE**
VERFAHREN ZUR HERSTELLUNG EINER FORM ZUR HERSTELLUNG EINES METALLISCHEN BAUTEILS DURCH METALLWACHSTUM
METHOD FOR MANUFACTURING A MOLD FOR FORMING A METAL PART BY METAL GROWTH

(30) Priorité: 07.10.2022 EP 22200410
(43) Date de publication de la demande: 10.04.2024
(73) Titulaire: Richemont International S.A., 1752 Villars-sur-Glâne (CH)
(72) Inventeur: CHABART, Mickaël, 2014 Fleurier (CH)
(74) Mandataire: Novagraaf International SA

(56) Documents cités:
- EP-A1- 3 454 122
- EP-A1- 3 547 027
- EP-A1- 3 839 627

## Description

### Domaine technique de l'invention

La présente invention concerne de manière générale la fabrication de moules pour former des pièces métalliques par galvanoplastie c'est à dire par croissance métallique galvanique ou autocatalytique (par électrodéposition ou bien dépose par un procédé sans courant appelé « electroless » ou dépôt autocatalytique qui crée des dépôts métalliques par réduction chimique autocatalytique de cations métalliques dans un bain liquide). De telles fabrications de moule font typiquement appel à des techniques de photolithographie UV où de la résine photosensible est irradiée au travers d'un masque pour pouvoir faire ensuite une gravure sélective de cette résine afin de générer des empreintes de moulage dans la résine. La présente invention concerne aussi la formation des pièces métalliques dans les moules précités.

### État de la technique

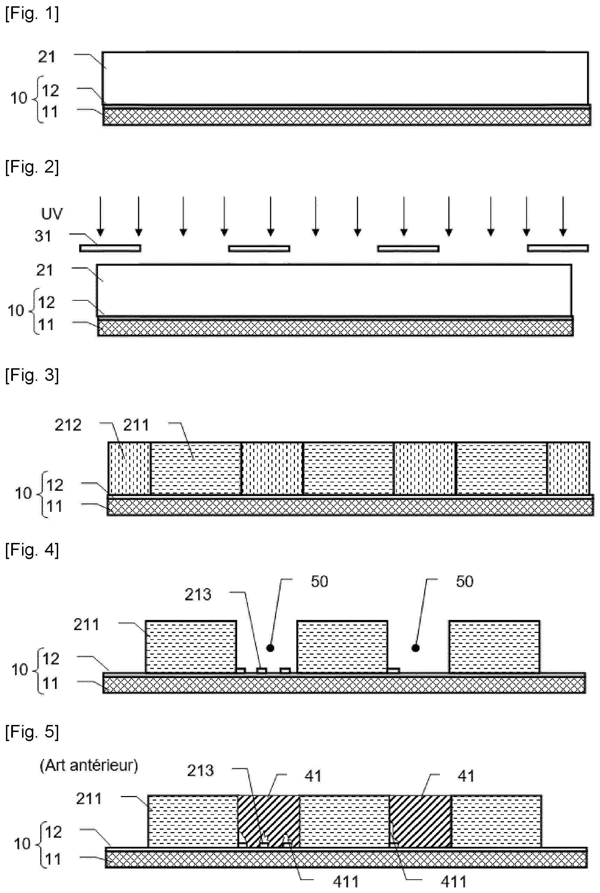

Dans l'art antérieur de fabrication de moules par photolithographie, on connait le document EP1835339A1 qui divulgue des étapes de développement de résine déposée sur un substrat pour former des empreintes destinées à faire croître un dépôt métallique pour former des pièces métalliques de formes complexes. En contrepartie, ce document ne donne pas de solutions pour garantir un début de croissance homogène à partir de toute la surface au fond des empreintes. En effet, des dépôts résiduels de résine ou impuretés en fond d'empreinte peuvent localement bloquer le dépôt de matière et créer ainsi des pièces avec des défauts d'aspect ou des dimensions incorrectes, comme le montre la figure 5 dans le cadre de formation de pièces métalliques comme dans l'art antérieur. Par ailleurs, il peut être important de ne pas déposer de métal sur les parois verticales ou flancs de l'empreinte, pour ne pas générer de croissance parasite à partir des parois verticales ou des flancs. Le document EP3454122A1 divulgue un procédé de fabrication d'une microstructure métallique multi-niveaux par une technologie de type LIGA.

### Exposé de l'invention

Un but de la présente invention est de répondre aux inconvénients de l'art antérieur mentionnés ci-dessus et en particulier, tout d'abord, de proposer un moule de fabrication de pièces métalliques par galvanoplastie et/ou croissance métallique et un procédé de fabrication de tels moules qui permettent de garantir de fabriquer des pièces métalliques exemptes de défauts d'aspect ou avec des dimensions correctes.

Un exemple qui ne fait pas partie de l'invention concerne un procédé de fabrication d'un moule pour fabriquer ou former au moins une pièce métallique par galvanoplastie et/ou croissance métallique, comprenant les étapes consistant à :
a- se munir d'un substrat présentant une surface de base et de préférence une surface conductrice de base,
b- déposer au moins une couche de résine photosensible sur la surface de base du substrat, la dépose étant effectuée par exemple à la tournette ou par une dépose d'une couche de résine solide (un film sec ou une feuille sèche de résine, à laminer),
c- irradier la couche de résine photosensible au travers d'un masque,
d- développer la couche de résine photosensible de sorte à creuser des cavités dans la couche de résine photosensible pour définir une empreinte de moulage dont le fond des cavités est au moins partiellement prévu pour amorcer la ou une croissance métallique de ladite au moins une pièce métallique,
caractérisé en ce que le procédé comprend, après l'étape d-, une étape consistant à uniformiser la ou une capacité d'amorçage du fond des cavités pour la fabrication de la pièce métallique par galvanoplastie et/ou croissance métallique.

Dans la présente demande, on peut considérer que la fabrication de pièces métalliques par galvanoplastie et/ou par croissance métallique galvanique ou autocatalytique couvre la fabrication de pièces métalliques par électrodéposition, par dépôt galvanique, et également la dépose par un procédé sans courant appelé « electroless » ou dépôt autocatalytique.

Le procédé selon la mise en œuvre ci-dessus comprend une étape consistant à uniformiser la capacité d'amorçage du fond des empreintes, c'est-à-dire une étape prévue pour procurer une surface ayant des propriétés continues et propres à assurer une croissance ou à tout le moins un départ de croissance homogène du dépôt métallique à partir de la surface au fond des cavités. En particulier, on peut considérer que cette étape consistant à uniformiser la capacité d'amorçage du fond des empreintes revient à dégager la surface de base si celle-ci est recouverte de résidus de résine, ou bien à rendre conductrice l'ensemble de la surface de base présente au fond des empreintes. Ainsi, les pièces métalliques produites sont exemptes de défauts et/ou présentent de dimensions correctes et conformes.

En particulier, l'invention concerne un procédé de fabrication d'un moule pour former au moins une pièce métallique par électrodéposition ou procédé « electroless », comprenant les étapes consistant à :
a- se munir d'un substrat présentant une surface de base et de préférence une surface conductrice de base,
b- déposer au moins une couche de résine photosensible sur la surface de base du substrat, sur la surface conductrice de base s'il y en a une, la dépose étant effectuée par exemple à la tournette ou par une dépose d'une couche de résine solide (un film sec ou une feuille sèche de résine, à laminer),
c- irradier la couche de résine photosensible au travers d'un masque,
d- développer la couche de résine photosensible de sorte à creuser des cavités dans la couche de résine photosensible pour définir une empreinte de moulage,
caractérisé en ce que le procédé comprend, après l'étape d-, une étape consistant à rendre conductrice au moins une partie du fond des cavités avec le dépôt d'au moins une sous couche d'accroche et d'au moins une couche conductrice.

Selon un mode de réalisation, l'étape consistant à uniformiser la capacité d'amorçage du fond des cavités pour la fabrication de la pièce métallique par galvanoplastie et/ou croissance métallique est une étape consistant à rendre conductrice au moins une partie du fond des cavités qui comprend une étape de formation d'une couche conductrice de recouvrement au fond des cavités par dépôt physique en phase vapeur. Typiquement, cette étape permet de garantir que l'ensemble de la surface de base en fond d'empreinte est conductrice de l'électricité. Dans le détail, on forme une fine pellicule métallique qui recouvre même les résidus de résine qui peuvent rester au fond des cavités.

Autrement dit, l'étape consistant à rendre conductrice au moins une partie du fond des cavités peut comprendre une étape de formation d'une couche conductrice de recouvrement au fond des cavités par dépôt physique en phase vapeur.

Selon un mode de réalisation, l'étape de formation d'une couche conductrice de recouvrement au fond des cavités peut être ajustée pour :
- dépasser une limite de percolation de la couche conductrice de recouvrement déposée au fond des cavités, et
- ne pas dépasser la limite de percolation de la couche conductrice de recouvrement déposée sur les flancs des cavités.

Selon la mise en oeuvre ci-dessus, le dépôt de la couche conductrice de recouvrement est prévu pour ne rendre conductrice que la surface de base en fond d'empreinte, et non les flancs ou parois verticales. Autrement dit, un courant électrique peut passer dans la couche conductrice de recouvrement au fond des cavités car la couche conductrice de recouvrement est suffisamment épaisse, alors que le courant électrique ne peut pas passer dans la couche conductrice de recouvrement sur les flancs ou parois verticales de la résine photosensible formant les parties en relief du moule, car la couche conductrice de recouvrement est trop fine (dans le détail, les rares particules de la couche conductrice de recouvrement déposées sur les flancs ou parois verticales sont trop éloignées les unes des autres pour conduire l'électricité).

Selon un mode de réalisation, l'étape de formation d'une couche conductrice de recouvrement au fond des cavités peut être ajustée pour former au fond des cavités une couche conductrice de recouvrement avec une épaisseur comprise dans une plage de valeurs allant de 2 nm à 15 nm, et de préférence dans une plage de valeurs allant de 3 nm à 10 nm. On peut noter que ces épaisseurs très faibles sont justes suffisantes à recouvrir des résidus de résine et/ou à rendre conductrice la surface des résidus qui resteraient au fond des empreintes du moule.

Selon un mode de réalisation, l'étape de formation d'une couche conductrice de recouvrement au fond des cavités peut être prévue pour former au fond des cavités une couche conductrice de recouvrement en or, ou en platine ou en palladium ou en argent ou en cuivre.

Selon un mode de réalisation, une sous-couche d'accroche par exemple en chrome, ou titane ou tantale, peut être préalablement formée avant la formation de la couche conductrice de recouvrement en or.

Selon un mode de réalisation, la sous-couche d'accroche peut présenter au fond des cavités une épaisseur comprise entre 0.5 nm et 10 nm, entre 1nm et 7 nm, entre 1 nm et 5 nm, entre 1 nm et 3 nm. Selon un mode de réalisation, la sous couche d'accroche peut être déposée par un procédé de dépôt par phase vapeur directionnel (de type PVD).

Selon un mode de réalisation, la couche conductrice peut présenter au fond des cavités une épaisseur comprise entre 1 nm et 20 nm, entre 2 nm et 15 nm, entre 3 nm et 10 nm, entre 3 nm et 8 nm. Selon un mode de réalisation, la couche conductrice peut être déposée par un procédé de dépôt par phase vapeur directionnel (de type PVD).

Selon un mode de réalisation, la sous couche d'accroche et la couche conductrice peuvent présenter au fond des cavités une épaisseur totale comprise entre 2 nm et 25 nm, entre 3 nm et 20 nm, entre 3 nm et 12 nm, entre 3 nm et 8 nm.

La demanderesse s'est aperçue que les épaisseurs de sous couche d'accroche, et/ou de couche conductrice et/ou d'épaisseur totale au fond des cavités ci-dessus permettent de garantir une bonne conductivité au fond des cavités (juste au dessus de la limite de percolation) sans que les flancs ou surfaces verticales du moule ne soient conducteurs (même si un peu de métal s'y dépose, la limite de percolation n'est pas atteinte).

Selon un mode de réalisation, la sous couche d'accroche et/ou la couche conductrice peut être déposée par un procédé de dépôt par phase vapeur directionnel (de type PVD) en plaçant par exemple une plaquette formant le substrat à au moins 500 mm de la source de matière à vaporiser et de préférence à au moins 700 mm de la source de matière à vaporiser.

Selon un mode de réalisation, le moule peut présenter, selon une dimension transverse à une direction de dépôt physique par phase vapeur, une taille d'au plus 20 cm, et de préférence d'au plus 16 cm. Typiquement, le moule peut être une plaquette de diamètre maximum 20 cm, et de préférence de diamètre maximum 16 cm. Selon un mode de réalisation, le moule peut présenter des cavités d'une profondeur comprise entre 20 µm et 2000 µm, entre 20 µm et 1500 µm, entre 30 µm et 1000 µm. Avec les dimensions ci-dessus, la demanderesse s'est aperçue que lors du dépôt physique par phase vapeur de la sous-couche d'accroche et/ou de la couche conductrice, les flancs (en particulier pour les parties en périphérie du substrat ou du moule, c'est-à-dire décalées par rapport à la cible) reçoivent environ 5 à 10 fois moins de dépôt que les surfaces au fond des cavités, si bien que si on effectue un dépôt juste à la limite (ou un peu au dessus) de percolation en fond de cavités, les flancs ne sont jamais conducteurs. Il n'y a pas besoin de prévoir d'étape de dissolution ou de décapage des flancs.

Selon un mode de réalisation, l'étape de formation d'une couche conductrice de recouvrement au fond des cavités peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Selon un mode de réalisation, l'étape consistant à uniformiser la capacité d'amorçage du fond des cavités pour la fabrication de la pièce métallique par galvanoplastie et/ou croissance métallique est une étape consistant à rendre conductrice au moins une partie du fond des cavités et comprend une étape d'exposition des cavités à un traitement plasma, ajustée pour dégager la surface de base du substrat, de préférence la couche conductrice de base s'il y en a une.

l'étape consistant à rendre conductrice au moins une partie du fond des cavités peut comprendre une étape d'exposition des cavités à un traitement plasma, ajustée pour dégager la surface de base du substrat, de préférence la couche conductrice de base s'il y en a une.

Selon un mode de réalisation, le traitement plasma peut comprendre la génération d'un plasma, de préférence à partir des gaz CF₄/O₂.

Selon un mode de réalisation, l'étape d'exposition des cavités à un traitement plasma peut être ajustée pour retirer une épaisseur de résine photosensible inférieure à 2 µm, de préférence inférieure à 1 µm.

Selon un mode de réalisation, l'étape d'exposition des cavités à un traitement plasma, de préférence un plasma micro-onde, peut être effectuée :
- pendant un intervalle de temps allant de 10 s à 1 min,
- dans une plage de températures allant de 22°C à 60°C,
- avec un débit allant de 50 sccm à 200 sccm de gaz CF₄ et un débit allant de 100 sccm à 600 sccm de gaz O₂,
- dans une plage de puissance allant de 100 W à 1000 W et de préférence de 100 W à 600 W,
- de préférence dans une cage de faraday.

Selon un mode de réalisation, l'étape d'exposition des cavités à un traitement plasma, de préférence un plasma micro-onde, comprend ensuite :
- un traitement plasma avec un débit de gaz O₂ allant de 100 sccm à 600 sccm et une puissance de 100 W à 1000 W et de préférence de 100 W à 600 W pendant une durée allant de 30 s à 5min,
et cette dernière étape peut être reproduite de 1 à 5 fois avec un temps d'attente de 1 à 5 min entre chaque traitement.

Selon un mode de réalisation, le procédé de fabrication peut comprendre plusieurs itérations des étapes b- à d- au moins pour former un moule avec plusieurs couches de résine photosensible, et dans lequel l'étape consistant à rendre conductrice au moins une partie du fond des cavités est effectuée après au moins une deuxième itération des étapes b- et d- au moins et de préférence après toutes les itérations des étapes b- et d- au moins.

Selon un mode de réalisation, la résine photosensible peut être composée de résine époxyde, de carbonate de propylène, d'un amorceur triaryl-sulfonium et d'un solvant organique, comme par exemple le cyclopentanone ou le gamma-butyrolactone, comme par exemple une résine SU-8.

Selon un mode de réalisation, l'étape a- peut comprendre une étape optionnelle consistant à déposer une sous couche (d'accroche) de chrome ou de titane ou de tantale et une étape consistant à déposer une couche propice à la croissance galvanique, comme une couche d'or ou de cuivre ou de palladium ou d'argent ou de platine sur le substrat pour former la surface conductrice.

Selon un mode de réalisation, les étapes a- à d- peuvent comprendre au moins :
- une étape de traitement thermique, et/ou
- une étape d'exposition à un rayonnement ultraviolet, et/ou
- une étape de traitement chimique telle qu'un bain d'acide.

Un autre but de la présente divulgation est de proposer un moule pour former des pièces métalliques par galvanoplastie et/ou croissance métallique (galvanique ou autocatalytique), dont les empreintes garantissent une croissance homogène et complète à partir du fond seulement, c'est-à-dire sans croissances parasites à partir des flancs ou des parois verticales. Un objet de l'invention est également de proposer un procédé pour fabriquer de tels moules.

Un autre exemple qui ne fait pas partie de l'invention concerne un moule de fabrication par électrodéposition d'une pièce d'horlogerie, comprenant :
- un substrat supportant au moins une couche de résine photosensible texturée,
- au moins une empreinte à remplir par électrodéposition pour former la pièce d'horlogerie, l'empreinte étant définie dans la couche de résine photosensible et comprenant un fond d'empreinte conducteur,
caractérisé en ce que la couche de résine photosensible comprend au moins un rebord qui s'étend au dessus d'une partie de l'empreinte. Un tel rebord, de préférence ménagé sur la surface supérieure de la résine texturée formant l'empreinte, permet de garantir que le fond d'empreinte peut être rendu conducteur par une métallisation effectuée après la formation de l'empreinte, sans déposer de métal sur les parois verticales ou flancs de l'empreinte. En effet, le rebord en question forme un écran qui empêche le dépôt de matière sur les parois verticales des empreintes. Le moule selon le deuxième aspect peut avoir été réalisé en faisant appel à un ou plusieurs modes de réalisation du premier aspect.

Selon un mode de réalisation, le moule peut comprendre une pluralité d'empreintes ayant chacune un fond d'empreinte conducteur, les fonds d'empreinte conducteurs étant électriquement reliés entre eux.

Selon un mode de réalisation, le rebord peut former une saillie sur un flanc de l'empreinte. La saillie est de préférence agencée sur la partie supérieure des flancs de l'empreinte, et de préférence sur la surface supérieure de la résine texturée formant l'empreinte.

Selon un mode de réalisation, le rebord peut faire partie d'une surface supérieure de la couche de résine photosensible.

Selon un mode de réalisation, le rebord peut former un surplomb au dessus de l'empreinte d'une dimension de saillie comprise entre 2 µm à 20 µm, et de préférence entre 2 µm et 8µm. Autrement dit, selon une direction horizontale et/ou parallèle au fond de l'empreinte, le rebord peut présenter une dimension ou une taille comprise entre 2 µm à 20 µm, et de préférence entre 2 µm et 8µm. En d'autres termes, selon une direction normale aux flancs de l'empreinte, le rebord peut présenter une dimension ou une taille comprise entre 2 µm à 20 µm, et de préférence entre 2 µm et 8µm.

Selon un mode de réalisation, le rebord peut former un surplomb continu au dessus de l'empreinte, le long d'une périphérie de l'empreinte.

Selon un mode de réalisation, le moule peut comprendre une couche conductrice déposée sur le fond d'empreinte et sur les parties supérieures de la couche de résine photosensible.

Un aspect pouvant être combiné avec l'invention se rapporte à un procédé de fabrication d'un moule pour former une pièce par électrodéposition, comprenant les étapes consistant à :
aa- se munir d'un substrat,
ab- former au moins une couche de résine photosensible sur le substrat,
ac- irradier la couche de résine photosensible au travers d'un masque,
ad- faire un premier traitement thermique à une température comprise entre 25°C et 65°C.
ae- recouvrir la couche de résine photosensible avec une couche de matériau comprenant au moins un solvant,
af- faire un deuxième traitement thermique à une température comprise entre 70°C et 95°C,
ag- développer la résine photosensible pour former au moins une empreinte laissant apparaitre le substrat et comprenant un rebord en partie supérieure,
ah- former une couche de matière au moins au fond de l'empreinte et de préférence sur les surfaces supérieures par dépôt physique en phase vapeur.

Le procédé selon l'invention et le procédé de l'aspect ci-dessus peuvent parfaitement être combinés et mis en œuvre pour la fabrication d'un même moule.

Selon un mode de réalisation, le procédé peut comprendre, après l'étape ag-, une étape consistant à uniformiser la ou une capacité d'amorçage du fond des cavités pour la fabrication de la pièce métallique par galvanoplastie et/ou croissance métallique

Selon un mode de réalisation, le premier traitement thermique peut être effectué pendant une durée allant de 5 min à plusieurs jours pour les plus basses températures.

Selon un mode de réalisation, le premier traitement thermique peut être effectué préférentiellement de 40 à 60°C de 30 min à 1h, de sorte à consommer une quantité contrôlée de photo-initiateur afin d'éviter la formation des rebords trop importants dans l'étape af.

Selon un mode de réalisation, le dit au moins solvant utilisé à l'étape ae peut permettre la mobilité de photo-initiateurs acides (activés par les UV) et/ou de la résine photosensible du type Su-8 (activés avec les photo-initiateur exposés aux UV). Les solvants peuvent être ceux présent dans la résine : cyclopentanone, PGMEA ; gamma-butyrolactone ... Le dit au moins solvant peut être de l'acétone et/ou un solvant permettant de dissoudre le photo initiateur activé et ou le Su-8 activé.

Selon un mode de réalisation, le deuxième traitement thermique peut être effectué pendant une durée allant de 5 min à 5h.

Selon un mode de réalisation, le dépôt physique en phase vapeur peut être directionnel. Les rebords de résine formés font alors écran (ou « parapluie ») et protègent les flancs d'un dépôt PVD. Les flancs restent ainsi non conducteurs. On peut prévoir d'ajuster l'étape de dépose pour atteindre ou juste dépasser une limite de percolation de conduite de courant électrique au fond des cavités, et pas sur les flancs ou parois verticales des parties activées, afin de ne pas perturber la croissance galvanique en cas de galvanoplastie par électrodéposition. Autrement dit, le fond des cavités est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités.

Selon un mode de réalisation, l'étape de formation d'une couche conductrice de recouvrement au fond des cavités peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Selon un mode de réalisation, l'étape af- peut consister à effectuer le deuxième traitement thermique après un temps prédéterminé de recouvrement de la couche de résine photosensible avec la couche de matériau comprenant au moins un solvant.

Selon un mode de réalisation, le temps prédéterminé peut être suffisant pour permettre une diffusion de catalyseurs ou d'agents réactifs dans la résine photosensible depuis une zone irradiée à l'étape ac- vers une zone non irradiée à l'étape ac-.

Selon un mode de réalisation, le temps prédéterminé peut être compris entre 1 min et 24 h.

Selon un mode de réalisation, le temps prédéterminé peut être suffisant pour permettre une diffusion de catalyseur ou d'agents réactifs sur une distance comprise allant de 2 µm à 20 µm, et de préférence allant de 2 µm à 8µm.

Selon un mode de réalisation, l'étape ae- peut consister à recouvrir la couche de résine photosensible avec une couche de matériau comprenant au moins un mélange de solvants.

Selon un mode de réalisation, on peut prévoir d'utiliser un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, l'étape ae- consiste à recouvrir la couche de résine photosensible avec un gel comprenant au moins un solvant.

Selon un mode de réalisation pour former un gel ou mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone (PVP) ... Un mélange visqueux est plus facile à déposer et les moules après dépôt sont plus faciles à manipuler

Selon un mode de réalisation, l'étape ae- peut consister à recouvrir la couche de résine photosensible avec une résine photosensible comprenant au moins un solvant. Un solvant permettant de dissoudre les sels photosensibles et /ou le polymère activé et un autre solvant ne réagissant pas avec le système. Ce mélange de solvant dissout de manière contrôlée (et faiblement) les constituants pour permettre une faible migration des constituants en surface des zones exposées et former ainsi un faible rebord.

On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

Selon un mode de réalisation, la résine photosensible peut être composée de résine époxyde, de carbonate de propylène, d'un amorceur triaryl-sulfonium et d'un solvant organique (cyclopentanone ou gamma-butyrolactone), comme par exemple une résine de type SU-8.

Selon un mode de réalisation, la couche de résine photosensible peut être déposée à l'étape ab- sur une surface du substrat non conductrice de l'électricité.

De plus, un exemple qui ne fait pas partie de l'invention se rapporte à un procédé de fabrication d'une pièce métallique, comprenant les étapes consistant à :
- fournir un moule fabriqué avec le procédé de fabrication selon le premier aspect de l'invention et/ou le troisième aspect de l'invention,
- fabriquer la pièce métallique par croissance métallique galvanique ou autocatalytique dans l'empreinte du moule.

Selon un mode de réalisation, la pièce métallique est une pièce horlogère.

### Description des figures

D'autres caractéristiques et avantages de la présente invention apparaîtront plus clairement à la lecture de la description détaillée qui suit de modes de réalisation de l'invention donnés à titre d'exemple nullement limitatifs et illustrés par les dessins annexés, dans lesquels :
[fig. 1] représente un moule pour former des pièces métalliques par galvanoplastie et/ou croissance métallique, en cours de fabrication selon le premier aspect de l'invention lorsqu'une résine photosensible a été déposée sur un substrat ;
[fig. 2] représente le moule de la figure 1, lors d'une irradiation de la résine photosensible au travers d'un masque ajouré ;
[fig. 3] représente le moule de la figure 2, une fois l'étape d'irradiation terminée, avec des parties de la résine activées par l'irradiation et des parties de la résine non activées ;
[fig. 4] représente le moule de la figure 3 après développement et retrait des parties de la résine non activées pour creuser des cavités formant des empreintes de moulage, des résidus de résine subsistant au fond des empreintes ;
[fig. 5] représente le moule de la figure 4, avec des pièces métalliques formées par galvanoplastie et/ou croissance métallique et comprenant des défauts comme dans l'art antérieur ;
[fig. 6] représente le moule de la figure 4, lors d'une étape selon le premier aspect de l'invention pour uniformiser la capacité d'amorçage du fond des cavités pour la fabrication des pièces métalliques par galvanoplastie et/ou croissance métallique ;
[fig. 7] représente le moule de la figure 6, avec des pièces métalliques formées par galvanoplastie et/ou croissance métallique et exemptes des défauts des pièces métalliques de la figure 5 ;
[fig. 8] représente le moule de la figure 4, lors d'une étape alternative selon le premier aspect de l'invention pour uniformiser la capacité d'amorçage du fond des cavités pour la fabrication des pièces métalliques par galvanoplastie et/ou croissance métallique ;
[fig. 9] représente le moule de la figure 8, avec des pièces métalliques formées par galvanoplastie et/ou croissance métallique et exemptes des défauts des pièces métalliques de la figure 5 ;
[fig. 10] représente une étape d'un procédé de fabrication d'un moule selon le troisième aspect de l'invention avec la fourniture d'un substrat conducteur ;
[fig. 11] représente une autre étape du procédé de fabrication d'un moule selon le troisième aspect de l'invention avec la formation d'une couche épaisse de résine photosensible sur le substrat ;
[fig. 12] représente une autre étape du procédé de fabrication d'un moule selon le troisième aspect de l'invention avec l'irradiation sélective de la couche épaisse de résine photosensible ;
[fig. 13] représente une autre étape du procédé de fabrication d'un moule selon le troisième aspect de l'invention avec la dépose d'une couche solvantée au dessus de la couche épaisse de résine photosensible ;
[fig. 14] représente une autre étape du procédé de fabrication d'un moule selon le troisième aspect de l'invention avec le développement de la couche épaisse de résine photosensible ;
[fig. 15] représente une autre étape du procédé de fabrication d'un moule selon le troisième aspect de l'invention avec le dépôt physique d'un métal en phase vapeur au fond de cavités de la couche épaisse de résine photosensible développée ;
[fig. 16] représente des résultats de mesures de résistance électrique effectuées sur des couches minces de chrome et d'or, déposées séquentiellement sur un substrat non conducteur, par exemple en silicium ou en résine.

### Description détaillée de mode(s) de réalisation

D'une manière générale, l'invention décrit ci-dessous est un procédé qui permet de fabriquer un moule avec les surfaces en fond de cavités propres à amorcer correctement et de manière homogène une croissance métallique.

La figure 1 représente un moule en cours de fabrication, le moule étant prévu pour former des pièces métalliques par galvanoplastie et/ou croissance métallique. En particulier la figure 1 représente le moule lorsqu'une résine photosensible 21 a été déposée sur un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane ou de tantale et une couche d'or ou de cuivre ou de palladium ou d'argent ou de platine. On peut noter que la couche conductrice de base 12 est optionnelle et peut être omise, en particulier si les pièces métalliques sont à former avec un procédé « electroless » ou par dépôt autocatalytique.

La résine photosensible 21 vient d'être déposée sur le substrat 10 et forme une couche homogène comme le montre la figure 1. La résine photosensible 21 est une résine photosensible négative couramment utilisée dans la fabrication de microsystèmes. Il s'agit d'un polymère très visqueux qui peut être tourné (dépose à la tournette) ou étalé sur une épaisseur allant de 1 micromètre à 2 millimètres. On peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer les ou les solvants et pour solidifier la résine.

On peut déposer la résine photosensible 21 en une ou plusieurs fois, sous forme visqueuse ou liquide, mais on peut également déposer une couche de résine photosensible 21 polymérisée et préparée à l'avance, comme une couche de résine solide (un film sec ou une feuille sèche de résine, à laminer).

La figure 2 montre l'étape d'irradiation à un rayonnement UV de la résine photosensible 21 au travers d'un masque 31, pour activer ou réticuler les parties de la résine photosensible 21 en regard des ouvertures du masque 31. Pour la résine SU-8 susmentionnée, on peut effectuer une irradiation à un rayonnement UV de longueur d'onde de 365 nm.

Comme le montre la figure 3, la résine photosensible 21 présente des parties activées 211 et des parties non activées 212. A l'issue de l'étape d'irradiation, un recuit peut encore être effectué, avant l'étape de développement dans un bain de solvant (par exemple du Propylène glycol méthyl éther acétate pour la résine SU-8). A l'issue du développement, les parties non activées 212 sont dissoutes et le moule de la figure 4 est obtenu.

On peut noter que les parties activées 211 forment des motifs en relief, entourant des cavités 50 qui laissent apparaître la surface conductrice de base de la couche conductrice 12. Les cavités 50 forment typiquement une ou plusieurs empreinte(s) pour réaliser la déposition de métal et former ainsi des pièces métalliques par galvanoplastie et/ou croissance métallique.

On peut noter que l'exemple décrit fait appel à une résine négative, mais on peut envisager d'utiliser une résine positive. De plus, il est possible de déposer, irradier et développer successivement plusieurs couches de résine photosensible pour créer des moule multi niveaux.

On peut noter également figure 4 que le fond des cavités 50 comprend des résidus 213 qui peuvent être typiquement des parties de résine photosensible 21 qui subsistent après le développement.

De tels résidus 213 sont typiquement un obstacle à l'amorçage homogène de la croissance galvanique ou du dépôt autocatalytique sur toute la surface au fond des cavités 50, ce qui peut entraîner des défauts dans les pièces métalliques formées.

En effet, la figure 5 montre des pièces métalliques 41 formées par galvanoplastie et/ou croissance métallique selon les techniques de l'art antérieur, lorsque des résidus 213 restent au fond des cavités 50. Ces résidus 213 forment des hétérogénéités sur la surface de base du substrat 10 et des vides, défauts d'aspect ou même défauts dimensionnels sont présents dans les pièces métalliques 41. On peut noter que les résidus 213 ont une épaisseur par exemple inférieure à 10 µm, de préférence inférieure à 5 µm, et très préférentiellement inférieure à 2 µm.

Afin de palier cet inconvénient, il est proposé, à l'issue du développement montré figure 4, de rendre l'ensemble des surfaces en fond des cavités 50 propices à un bon amorçage de la croissance ou du dépôt métallique.

En particulier, il est proposé d'amorcer la surface en fond des cavités 50, c'est-à-dire à rendre la surface en fond des cavités 50 homogène ou continue (en termes de conductivité électrique, composition, rugosité...) pour démarrer la croissance ou le dépôt métallique de manière uniforme et sans les défauts 411 visibles figure 5.

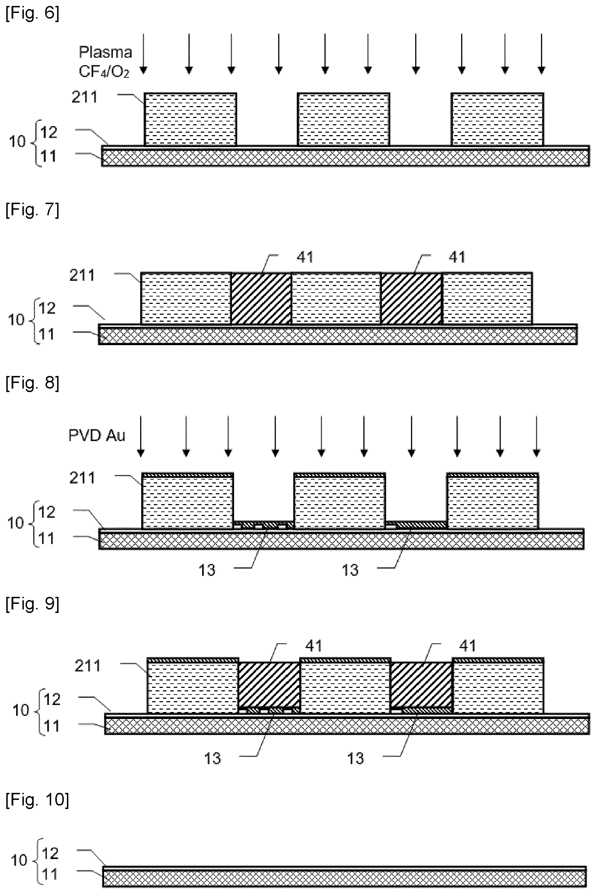

La figure 6 montre une première alternative du premier aspect de l'invention pour amorcer la surface au fond des cavités 50 (c'est-à-dire rendre la surface au fond des cavités 50 propice à un bon amorçage de la croissance ou du dépôt métallique). Selon cette première étape, il est proposé d'exposer le moule à un traitement plasma, généré à partir des gaz CF₄/O₂.

En particulier, l'étape d'exposition des cavités à un traitement plasma, de préférence un plasma micro-onde, est effectuée :
- pendant un intervalle de temps allant de 10 s à 1 min,
- dans une plage de températures allant de 22°C à 60°C,
- avec un débit allant de 50 sccm (Standard Cubic Centimeters per Minute) à 200 sccm de gaz CF₄ et un débit allant de 100 sccm à 600 sccm de gaz O₂,
- dans une plage de puissance allant de 100 W à 600 W,
- de préférence dans une cage de faraday.

En tout état de cause, le traitement au plasma est ajusté en temps pour retirer les résidus 213 et pas plus. Autrement dit, le traitement au plasma est ajusté pour ne retirer au plus 1 µm de résine photosensible. On peut prévoir par exemple de former les parties activées 211 à des dimensions augmentées d'un micromètre à l'étape d'irradiation de la figure 2, afin d'obtenir après le traitement plasma de la figure 6 un dimensionnel apte à former des pièces métalliques aux bonnes dimensions. En conséquence, le moule de la figure 6 ne présente plus de résidus 213 en fond des cavités 50, et la formation de pièces métalliques 41 aboutit figure 7 à des pièces exemptes des défauts 411 que l'on peut rencontrer sur les pièces métalliques 41 de l'art antérieur représentées figure 5.

Une autre possibilité du premier aspect de l'invention pour former des pièces métalliques exemptes des défauts 411 représentés figure 5 est de prévoir une étape, après le développement de la résine photosensible 21, consistant à recouvrir le fond des empreintes ou des cavités 50 avec une couche conductrice. On peut par exemple prévoir une fine couche d'or formée par dépôt physique en phase vapeur, comme le montre la figure 8.

Sur la figure 8, le moule (développé, obtenu figure 4 et comprenant des résidus 213 en fond de cavités 50) est placé dans une enceinte fermée pour effectuer un dépôt physique d'or en phase vapeur, afin de créer une couche conductrice de recouvrement 13 au moins au fond des cavités 50. On peut noter que le dépôt physique d'or en phase vapeur génère aussi une couche conductrice de recouvrement 13 au sommet des parties activées 211, mais on pourrait limiter ce dépôt au sommet des parties activées 211avec l'utilisation d'un masque.

Le dépôt physique d'or en phase vapeur est ajusté pour juste recouvrir les résidus 213 et/ou pour atteindre la limite de percolation de conduite de courant électrique au fond des cavités 50, et pas sur les flancs ou parois verticale des parties activées 211, afin de ne pas perturber la croissance galvanique en cas de galvanoplastie par électrodéposition. En conséquence, comme le fond des cavités 50 est parfaitement conducteur de l'électricité avec la couche conductrice de recouvrement 13, l'amorçage de la croissance galvanique ou du dépôt autocatalytique de matière métallique se fait de manière uniforme à partir du fond des cavités 50, si bien que les pièces métalliques 41 de la figure 9, formées dans le moule de la figure 8, sont exemptes des défauts 411 que l'on peut rencontrer sur les pièces métalliques 41 de l'art antérieur représentées figure 5.

La figure 10 représente une première étape d'un procédé de fabrication d'un moule selon le troisième aspect de l'invention qui consiste à se munir d'un substrat 10 comprenant une âme 11 en silicium et une couche conductrice de base 12.

L'âme 11 est une plaquette en silicium, mais on peut envisager d'utiliser une plaquette en verre, ou une plaquette en céramique ou même une plaquette métallique. La couche conductrice de base 12 peut comprendre une sous couche de chrome ou de titane et une couche d'or ou de cuivre.

On peut noter que la couche conductrice de base 12 est optionnelle et peut être omise.

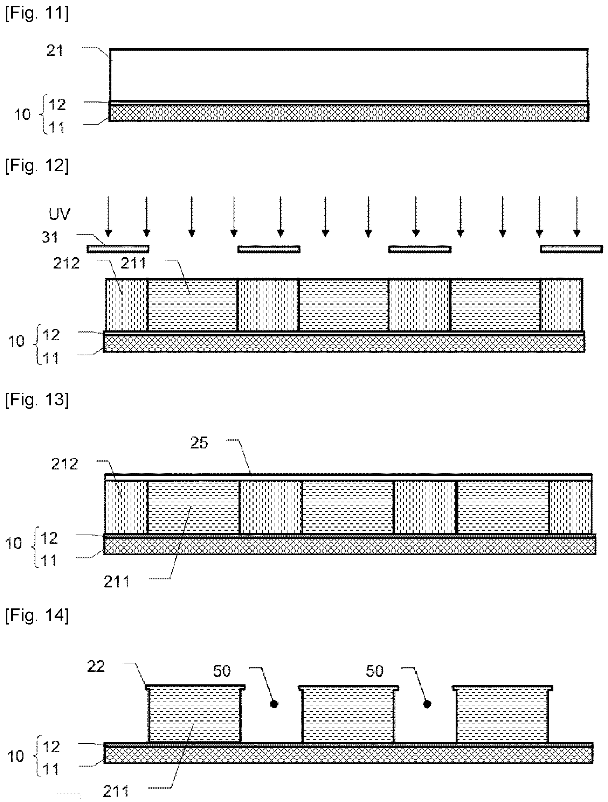

La figure 11 représente le moule de la figure 10 recouvert d'une couche épaisse de résine photosensible 21 qui formera en tout ou partie le moule à proprement parler. On peut appliquer une résine photosensible 21 liquide ou visqueuse, par exemple à la tournette ou par application au cylindre, ou on peut alternativement déposer / laminer une couche de résine solide du type lamina (un film sec ou une feuille sèche de résine, à laminer).

En ce qui concerne spécifiquement une couche de résine solide du type lamina (un film de résine sèche), plusieurs épaisseurs de ces films sont proposées dans le commerce et permettent d'éviter une phase de rectification car la planéité et l'épaisseur sont contrôlées. Une épaisseur couramment utilisée est de 150 µm.

La résine photosensible 21 est une résine photosensible négative couramment utilisée dans la fabrication de microsystèmes. Il s'agit d'un polymère très visqueux qui peut être tourné (dépose à la tournette) ou étalé sur une épaisseur allant de 1 micromètre à 2 millimètres. On peut par exemple utiliser une résine SU-8 composée de résine époxyde, de carbonate de propylène, de l'amorceur triaryl-sulfonium et d'un solvant organique (cyclopentanone ou gamma-butyrolactone, selon la formulation). On peut ensuite effectuer un chauffage ou un recuit (« pre-bake ») pour évaporer le ou les solvants et pour solidifier la résine.

On peut déposer la résine photosensible 21 en une ou plusieurs fois, sous forme visqueuse ou liquide ou encore solide (un film sec ou une feuille sèche de résine non réticulée, à laminer), mais on peut également déposer une couche de résine photosensible 21 polymérisée et préparée à l'avance.

La figure 12 montre l'étape d'irradiation à un rayonnement UV de la résine photosensible 21 au travers d'un masque 31, pour activer ou réticuler les parties de la résine photosensible 21 en regard des ouvertures du masque 31. Pour la résine SU-8 susmentionnée, on peut effectuer une irradiation à un rayonnement UV de longueur d'onde de 365 nm.

Comme le montre la figure 12, la résine photosensible 21 présente alors des parties activées 211 et des parties non activées 212. A l'issue de l'étape d'irradiation, un recuit peut encore être effectué.

Au lieu de passer à l'étape de développement de la résine photosensible 21, il est proposé de réaliser un premier traitement thermique à une température comprise entre 25°C et 65°C et de déposer sur la résine photosensible 21 partiellement réticulée une couche solvantée 25 (c'est-à-dire une couche formée par un matériau comprenant au moins un solvant pouvant dissoudre les sels activés ou le polymère activé), comme le montre la figure 13, puis de faire un deuxième traitement thermique à une température comprise entre 70°C et 95°C.

En ce qui concerne spécifiquement la couche de résine solide du type lamina (un film de résine sèche) qui peut être utilisée, le premier traitement thermique est plus court et peut être effectué à plus basse température car il y a peu ou pas de solvant à évaporer. Le procédé de lithographie est raccourci d'une manière importante.

Le but de ces opérations est de provoquer une migration ou une diffusion des acides photo-initiateurs présents dans les parties activées 211 vers les parties non activées 212, afin d'étendre depuis les parties activées 211 la réticulation de la résine horizontalement et sur une couche proche de la surface.

D'une manière générale, le premier traitement thermique est effectué pendant une durée allant de 5 min à plusieurs jours pour les plus basses températures. Le premier traitement thermique est effectué préférentiellement de 40 à 60°C de 30 min à 1h. Ce premier traitement thermique a pour effet de provoquer une réticulation plus complète de la résine photosensible 21, pour éviter qu'une trop grande quantité acides photo-initiateurs ne migre vers les parties non activées 212.

En ce qui concerne la couche solvantée 25, celle-ci a pour fonction de provoquer et/ou permettre et/ou véhiculer la migration ou la diffusion des acides photo-initiateurs vers les parties non activées 212. On peut prévoir pour la couche solvantée 25 de simplement déposer de la résine photosensible liquide, ou un gel comprenant un solvant ou un mélange de solvants ou directement un solvant ou un mélange de solvants. Dans le détail, on peut prévoir d'utiliser au moins un premier solvant permettant de dissoudre les sels photosensibles et /ou le polymère activé de la couche épaisse de résine photosensible 21 et un deuxième solvant ne réagissant pas avec le système (pour contrôler et/ou ajuster le pouvoir de dissolution du premier solvant). Ce mélange de solvants dissout de manière contrôlée (et faiblement) les constituants pour permettre une faible migration des constituants en surface des zones exposées et former ainsi un faible rebord. On peut prévoir par exemple un solvant (pouvant dissoudre les sels photosensibles et /ou le polymère activé) choisi parmi : cyclopentanone, PGMEA, acétone ; gamma-butyrolactone ... On peut prévoir par exemple l'Isopropylalcool comme solvant ne réagissant pas.

En ce qui concerne les modes de réalisation avec un gel, en particulier pour former un gel ou un mélange visqueux de solvant, on peut par exemple prévoir de dissoudre dans un solvant (ou un mélange de solvant) un polymère ne réagissant pas avec le système, comme par exemple le polyéthylène glycol ou PEG ou encore la polyvinylpyrrolidone (PVP) ... Un mélange visqueux est plus facile à déposer et les moules après dépôt sont plus faciles à manipuler.

En ce qui concerne le deuxième traitement thermique il peut être effectué pendant une durée allant de 5 min à 5h, pour permettre la réticulation des zones des parties non activées 212 qui ont reçu des acides photo-initiateurs. Ainsi, en surface de la résine photosensible 21, les parties activées 211 « débordent » désormais sur les parties non activées 212 avec des rebords 22 qui restent en place après développement comme le montre la figure 14.

Les rebords 22 de la figure 14 présentent une dimension horizontale comprise entre 2 µm à 20 µm, et de préférence entre 2 µm et 8µm. On peut noter que cette dimension peut être ajustée au moins par :
- la durée et la température du premier traitement thermique (plus ce dernier sera chaud et long, plus les rebords seront étroits car la migration sera rendue plus difficile),
- la durée laissée entre le premier traitement thermique et le deuxième traitement thermique (plus la couche solvantée sera laissée longtemps sur la résine photosensible 21 avant le deuxième traitement thermique, plus les rebords seront larges),
- la quantité et la nature des solvants utilisés.

Après le deuxième traitement thermique appliqué sur le moule de la figure 13, on peut procéder au développement dans un bain de solvant (par exemple du Propylene glycol methyl ether acétate pour la résine SU-8). A l'issue du développement, les parties non activées 212 sont dissoutes et le moule de la figure 14 est obtenu.

On peut noter que les parties activées 211 munies des rebords 22 forment des motifs en relief, entourant des cavités 50 qui laissent apparaître la couche conductrice de base 12 (qui est optionnelle comme expliqué ci-dessus). Les cavités 50 forment typiquement une ou plusieurs empreinte(s) pour réaliser la déposition de métal et former ainsi des pièces métalliques par galvanoplastie et/ou croissance métallique.

On peut noter que l'exemple décrit fait appel à une résine négative, mais on peut envisager d'utiliser une résine positive. De plus, il est possible de déposer, irradier et développer successivement plusieurs couches de résine photosensible pour créer un moule multi niveaux. Dans ce cas, on peut prévoir de former des rebords 22 sur chaque couche épaisse de résine photosensible, et /ou uniquement sur le haut des structures du dernier niveau.

Même si dans l'exemple représenté le fond des cavités 50 est normalement formé par la couche conductrice de base 12, cette dernière peut être absente ou recouverte de résidus non conducteurs qui affecteront la croissance galvanique.

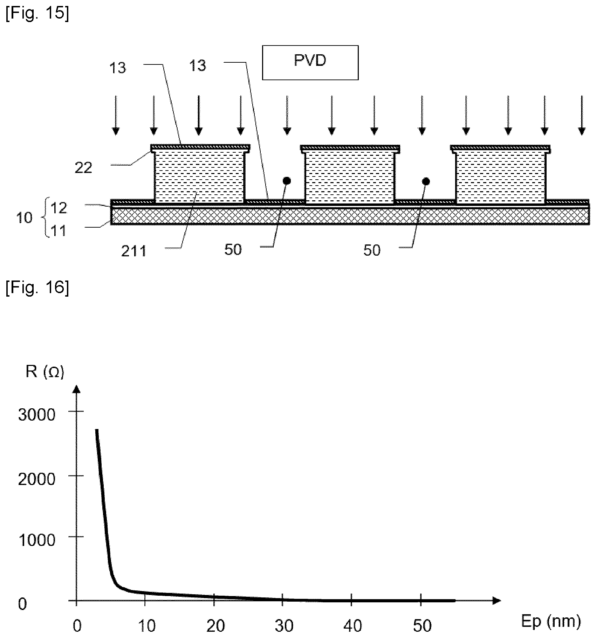

La figure 15 représente le moule de la figure 14 auquel on applique une étape de dépôt physique de métal sous forme vapeur, pour déposer par exemple de l'or au fond des cavités 50 pour former une couche conductrice de recouvrement 13. On peut prévoir d'ajuster l'étape de dépose pour atteindre ou juste dépasser une limite de percolation de conduite de courant électrique au fond des cavités 50, et pas sur les flancs ou parois verticales des parties activées 211, afin de ne pas perturber la croissance galvanique en cas de galvanoplastie par électrodéposition. Autrement dit, le fond des cavités 50 est recouvert d'une couche suffisamment épaisse pour pouvoir conduire le courant électrique, alors que les flancs sont exempts de revêtement conducteur ou avec des particules conductrices trop éloignées les unes des autres pour pouvoir conduire le courant électrique. On peut prévoir d'effectuer le dépôt physique de métal sous forme vapeur de manière directionnelle, selon une direction parallèle aux flancs des cavités 50.

Selon un mode de réalisation, l'étape de formation d'une couche conductrice de recouvrement 13 au fond des cavités 50 peut être effectuée :
- sous niveau de vide inférieur à 10⁻⁴ mbar, et de préférence inférieur à 10⁻⁶ mbar,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

Une telle couche conductrice de recouvrement 13 a pour effet de permettre une croissance homogène depuis toute la surface inférieure, si le substrat 10 est exempt de de couche conductrice de base 12, ou pour garantir une croissance homogène si la couche conductrice de base 12 est présente mais recouverte par endroits ou en totalité par des résidus. Lors de cette étape de dépôt physique en phase vapeur, qui est directionnel (selon la direction verticale de la figure 15), la présence des rebords 22 garantit l'absence de dépôt métallique sur les flancs ou les parois verticales des cavités 50. Ainsi, la couche conductrice de recouvrement 13 recouvre le fond des cavités 50 et la surface supérieure des parties activées 211 et pas les flancs verticaux, si bien que la croissance dans les cavités 50 lors d'une électrodéposition se fera de manière homogène à partir du fond des cavités 50, sans croissance parasite depuis les parois verticales.

On peut noter que juste avant d'effectuer le dépôt physique par phase vapeur d'or des figures 8 ou 15, il est prévu de faire un dépôt physique par phase vapeur d'une sous-couche d'accroche de préférence en chrome, ou par exemple en titane ou tantale. La sous-couche d'accroche peut présenter au fond des cavités une épaisseur comprise entre 1 nm et 3 nm. La couche conductrice en or déposée ensuite peut présenter au fond des cavités une épaisseur comprise entre 1 nm et 8 nm.

La figure 16 représente des essais de mesures de résistance électrique effectués sur des pièces ayant reçu une sous-couche d'accroche de chrome, et une couche conductrice en or, en fonction de l'épaisseur totale de déposition. Les deux pointes de mesure de l'ohmmètre sont disposées à 10 mm l'une de l'autre et la résistance électrique est mesurée. On peut noter que la résistance électrique décroit très rapidement pour des épaisseurs allant de 0 nm à 7 nm, et que la résistance électrique décroit plus lentement pour des épaisseurs allant de 7-8 nm à 25 nm environ, pour être ensuite nulle.

Lors d'un dépôt physique par phase vapeur directionnel, effectué sur une plaquette de 150 mm de diamètre, la plaquette étant disposée à 70 cm de la source de matière à déposer (la cible), on peut considérer qu'on dépose environ 10 fois moins de matière sur les flancs verticaux du moule qu'au fond des cavités (en particulier pour les parties excentrées du moule, agencées en périphérie). Ainsi, avec une épaisseur totale en fond de cavité comprise entre 3 nm et 8 nm (par exemple 1 à 3 nm, par exemple 2 nm de chrome et 2 à 5 nm, par exemple 3 nm d'or), dans la zone où la résistance électrique commence à décroître plus lentement sur la figure 16, on peut garantir une résistance électrique convenable pour le dépôt galvanique en fond de cavités, et une résistance électrique très élevée voire infinie sur les flancs. Ainsi, il n'y a pas de croissance parasite depuis les flancs des cavités. On peut prévoir toute méthode connue de mesure de l'épaisseur des couches (réflectométrie, ellipsométrie, TEM (microscopie électronique à transmission), SEM (microscopie électronique à balayage) ou de préférence par des études au microscope optique pour déterminer l'épaisseur des couches - couleurs d'interférence caractéristiques). En particulier, on peut prévoir de mesurer les épaisseurs déposées avec un interféromètre optique du type par exemple Veeco NT3300.

### Application industrielle

Un procédé de fabrication de moule selon la présente invention, et l'utilisation de ces moules pour former des pièces métalliques, sont susceptibles d'application industrielle.

On comprendra que diverses modifications et/ou améliorations évidentes pour l'homme du métier peuvent être apportées aux différents modes de réalisation de l'invention décrits dans la présente description sans sortir du cadre de l'invention défini par les revendications.

## Revendications

1. Procédé de fabrication d'un moule pour former au moins une pièce métallique (41) par croissance métallique, comprenant les étapes consistant à :
a- se munir d'un substrat (10) présentant une surface de base et de préférence une surface conductrice de base,
b- déposer au moins une couche de résine photosensible (21) sur la surface de base du substrat (10),
c- irradier la couche de résine photosensible (21) au travers d'un masque (31),
d- développer la couche de résine photosensible (21) de sorte à creuser des cavités (50) dans la couche de résine photosensible (21) pour définir une empreinte de moulage dont le fond des cavités est au moins partiellement prévu pour amorcer la croissance métallique de ladite au moins une pièce métallique,
**caractérisé en ce que** le procédé comprend, après l'étape d-, une étape consistant à uniformiser la capacité d'amorçage du fond des cavités (50) pour la fabrication de la pièce métallique (41) par croissance métallique avec le dépôt d'au moins une sous couche d'accroche et d'au moins une couche conductrice (13).

2. Procédé de fabrication selon la revendication 1, dans lequel l'étape consistant à uniformiser la capacité d'amorçage du fond des cavités (50) est une étape consistant à rendre conductrice au moins une partie du fond des cavités (50) qui comprend une étape de formation d'une couche conductrice de recouvrement (13) au fond des cavités (50) par dépôt physique en phase vapeur.

3. Procédé de fabrication selon la revendication 2, dans lequel l'étape de formation d'une couche conductrice de recouvrement (13) au fond des cavités (50) comprend un dépôt physique de métal sous forme vapeur de manière directionnelle, selon une direction parallèle aux flancs des cavités, et le dépôt physique de métal sous forme vapeur est ajusté pour :
- dépasser une limite de percolation de la couche conductrice de recouvrement (13) déposée au fond des cavités (50), et
- ne pas dépasser la limite de percolation de la couche conductrice de recouvrement (13) déposée sur les flancs des cavités (50).

4. Procédé de fabrication selon l'une des revendications 2 ou 3, dans lequel l'étape de formation d'une couche conductrice de recouvrement (13) au fond des cavités (50) est ajustée pour former au fond des cavités (50) une couche conductrice de recouvrement (13) avec une épaisseur comprise dans une plage de valeurs allant de 2 nm à 15 nm, et de préférence dans une plage de valeurs allant de 3 nm à 10 nm.

5. Procédé de fabrication selon l'une des revendications 2 à 4, dans lequel l'étape de formation d'une couche conductrice de recouvrement (13) au fond des cavités (50) est prévue pour former au fond des cavités (50) une couche conductrice de recouvrement (13) en or, ou en platine ou en palladium ou en argent ou en cuivre.

6. Procédé de fabrication selon la revendication 5, dans lequel ladite sous couche d'accroche est préalablement formée, par exemple en chrome, ou titane ou tantale.

7. Procédé de fabrication selon l'une des revendications 2 à 6, dans lequel l'étape de formation d'une couche conductrice de recouvrement (13) au fond des cavités (50) est effectuée :
- sous niveau de vide inférieur à 10⁻⁴ mbar, et de préférence inférieur à 10⁻⁶ mbar ,
- en plaçant par exemple une plaquette de 150 mm de côté ou de diamètre formant le substrat à au moins 500 mm de la source de matière à vaporiser et de préférence à au moins 700 mm de la source de matière à vaporiser, et/ou en chauffant la source de matière à vaporiser juste au dessus de sa température de fusion,
- en utilisant une source métallique pure à 99% au moins, comme par exemple une source d'or pur à 99% en poids.

8. Procédé de fabrication selon l'une des revendications 1 à 7, comprenant plusieurs itérations des étapes b- à d- au moins pour former un moule avec plusieurs couches de résine photosensible (21), et dans lequel l'étape consistant à rendre conductrice au moins une partie du fond des cavités (50) est effectuée après au moins une deuxième itération des étapes b- et d- au moins et de préférence après toutes les itérations des étapes b- et d- au moins.

9. Procédé de fabrication selon l'une des revendications 1 à 8, dans lequel la résine photosensible (21) est composée de résine époxyde, de carbonate de propylène, d'un amorceur triaryl-sulfonium et d'un solvant organique (cyclopentanone ou gamma-butyrolactone), comme par exemple une résine SU-8.

10. Procédé de fabrication selon l'une des revendications 1 à 9, dans lequel l'étape a- comprend :
- une étape optionnelle consistant à déposer une sous couche de chrome ou de titane ou de tantale et
- une étape consistant à déposer une couche propice à la croissance métallique, comme une couche d'or ou de cuivre ou de palladium ou d'argent ou de platine sur le substrat (10) pour former la surface conductrice.

11. Procédé de fabrication selon l'une des revendications 1 à 10, dans lequel les étapes a- à d- comprennent au moins :
- une étape de traitement thermique, et/ou
- une étape d'exposition à un rayonnement ultraviolet, et/ou
- une étape de traitement chimique telle qu'un bain d'acide.

12. Procédé de fabrication d'une pièce métallique (41) par électrodéposition, comprenant :
- le procédé de fabrication d'un moule selon l'une des revendications 1 à 11,
- la fabrication d'une pièce métallique (41) dans le moule par électrodéposition.

13. Procédé de fabrication d'une pièce métallique (41) selon la revendication 12, dans lequel la pièce métallique (41) est une pièce horlogère.

## Patentansprüche

1. Verfahren zur Herstellung einer Form zum Bilden mindestens eines Metallteils (41) durch metallisches Wachstum, umfassend die Schritte, die darin bestehen:
a- ein Substrat (10) bereitzustellen, das eine Grundfläche und vorzugsweise eine leitfähige Grundfläche aufweist,
b- mindestens eine Schicht aus fotoempfindlichem Harz (21) auf die Grundfläche des Substrats (10) aufzubringen,
c- die Schicht aus fotoempfindlichem Harz (21) durch eine Maske (31) hindurch zu bestrahlen,
d- die Schicht aus fotoempfindlichem Harz (21) zu entwickeln, um so Hohlräume (50) in der Schicht aus fotoempfindlichem Harz (21) auszuhöhlen, um einen Formabdruck zu definieren, wobei der Boden der Hohlräume zumindest teilweise dazu vorgesehen ist, das metallische Wachstum des mindestens einen Metallteils zu initiieren,
**dadurch gekennzeichnet, dass** das Verfahren nach dem Schritt d- einen Schritt umfasst, der darin besteht, die Initiierungskapazität des Bodens der Hohlräume (50) für die Herstellung des Metallteils (41) durch metallisches Wachstum durch das Abscheiden mindestens einer Haftunterschicht und mindestens einer leitfähigen Schicht (13) zu vereinheitlichen.

2. Herstellungsverfahren nach Anspruch 1, bei dem der Schritt, der darin besteht, die Initiierungskapazität des Bodens der Hohlräume (50) zu vereinheitlichen, ein Schritt ist, der darin besteht, zumindest einen Teil des Bodens der Hohlräume (50) leitfähig zu machen, der einen Schritt des Bildens einer leitfähigen Deckschicht (13) am Boden der Hohlräume (50) durch physikalische Gasphasenabscheidung umfasst.

3. Herstellungsverfahren nach Anspruch 2, bei dem der Schritt des Bildens einer leitfähigen Deckschicht (13) am Boden der Hohlräume (50) eine physikalische Abscheidung von Metall in Dampfform auf gerichtete Weise, entlang einer Richtung parallel zu den Flanken der Hohlräume, umfasst, und die physikalische Abscheidung von Metall in Dampfform eingestellt ist, um:
- eine Perkolationsgrenze der am Boden der Hohlräume (50) abgeschiedenen leitfähigen Deckschicht (13) zu überschreiten, und
- die Perkolationsgrenze der an den Flanken der Hohlräume (50) abgeschiedenen leitfähigen Deckschicht (13) nicht zu überschreiten.

4. Herstellungsverfahren nach einem der Ansprüche 2 oder 3, bei dem der Schritt des Bildens einer leitfähigen Deckschicht (13) am Boden der Hohlräume (50) eingestellt ist, um am Boden der Hohlräume (50) eine leitfähige Deckschicht (13) mit einer Dicke zu bilden, die in einem Wertebereich von 2 nm bis 15 nm und vorzugsweise in einem Wertebereich von 3 nm bis 10 nm liegt.

5. Herstellungsverfahren nach einem der Ansprüche 2 bis 4, bei dem der Schritt des Bildens einer leitfähigen Deckschicht (13) am Boden der Hohlräume (50) dazu vorgesehen ist, am Boden der Hohlräume (50) eine leitfähige Deckschicht (13) aus Gold oder aus Platin oder aus Palladium oder aus Silber oder aus Kupfer zu bilden.

6. Herstellungsverfahren nach Anspruch 5, bei dem die besagte Haftunterschicht vorab gebildet wird, zum Beispiel aus Chrom oder Titan oder Tantal.

7. Herstellungsverfahren nach einem der Ansprüche 2 bis 6, bei dem der Schritt des Bildens einer leitfähigen Deckschicht (13) am Boden der Hohlräume (50) durchgeführt wird:
- unter einem Vakuumniveau von weniger als 10⁻⁴ mbar und vorzugsweise weniger als 10⁻⁶ mbar,
- indem zum Beispiel ein Wafer mit 150 mm Seitenlänge oder Durchmesser, der das Substrat bildet, in mindestens 500 mm Abstand von der zu verdampfenden Materialquelle und vorzugsweise in mindestens 700 mm Abstand von der zu verdampfenden Materialquelle angeordnet wird, und/oder indem die zu verdampfende Materialquelle knapp über ihre Schmelztemperatur erhitzt wird,
- indem eine metallische Quelle verwendet wird, die zu mindestens 99 % rein ist, wie zum Beispiel eine Goldquelle, die zu 99 Gew.-% rein ist.

8. Herstellungsverfahren nach einem der Ansprüche 1 bis 7, umfassend mehrere Iterationen zumindest der Schritte b- bis d-, um eine Form mit mehreren Schichten aus fotoempfindlichem Harz (21) zu bilden, und bei dem der Schritt, der darin besteht, zumindest einen Teil des Bodens der Hohlräume (50) leitfähig zu machen, nach zumindest einer zweiten Iteration zumindest der Schritte b- und d- und vorzugsweise nach allen Iterationen zumindest der Schritte b- und d- durchgeführt wird.

9. Herstellungsverfahren nach einem der Ansprüche 1 bis 8, bei dem das fotoempfindliche Harz (21) aus Epoxidharz, aus Propylencarbonat, aus einem Triarylsulfonium-Initiator und aus einem organischen Lösungsmittel (Cyclopentanon oder gamma-Butyrolacton) zusammengesetzt ist, wie zum Beispiel ein SU-8-Harz.

10. Herstellungsverfahren nach einem der Ansprüche 1 bis 9, bei dem der Schritt a- umfasst:
- einen optionalen Schritt, der darin besteht, eine Unterschicht aus Chrom oder aus Titan oder aus Tantal abzuscheiden, und
- einen Schritt, der darin besteht, eine für das metallische Wachstum günstige Schicht abzuscheiden, wie eine Schicht aus Gold oder aus Kupfer oder aus Palladium oder aus Silber oder aus Platin auf dem Substrat (10), um die leitfähige Fläche zu bilden.

11. Herstellungsverfahren nach einem der Ansprüche 1 bis 10, bei dem die Schritte a- bis d- zumindest umfassen:
- einen Wärmebehandlungsschritt, und/oder
- einen Schritt des Aussetzens einer Ultraviolettstrahlung, und/oder
- einen chemischen Behandlungsschritt wie etwa ein Säurebad.

12. Verfahren zur Herstellung eines Metallteils (41) durch Elektroabscheidung, umfassend:
- das Verfahren zur Herstellung einer Form nach einem der Ansprüche 1 bis 11,
- die Herstellung eines Metallteils (41) in der Form durch Elektroabscheidung.

13. Herstellungsverfahren eines Metallteils (41) nach Anspruch 12, bei dem das Metallteil (41) ein Uhrenteil ist.

## Claims

1. Method for manufacturing a mould for forming at least one metal part (41) by metal growth, comprising the steps consisting in:
a- providing a substrate (10) having a base surface and preferably a conductive base surface,
b- depositing at least one layer of photosensitive resin (21) on the base surface of the substrate (10),
c- irradiating the layer of photosensitive resin (21) through a mask (31),
d- developing the layer of photosensitive resin (21) so as to hollow out cavities (50) in the layer of photosensitive resin (21) in order to define a moulding impression, the bottom of the cavities of which is at least partially intended to initiate the metal growth of said at least one metal part,
**characterised in that** the method comprises, after step d-, a step consisting in making uniform the initiation capacity of the bottom of the cavities (50) for the manufacture of the metal part (41) by metal growth with the deposition of at least one adhesion sub-layer and of at least one conductive layer (13).

2. Manufacturing method according to claim 1, wherein the step consisting in making uniform the initiation capacity of the bottom of the cavities (50) is a step consisting in making at least part of the bottom of the cavities (50) conductive, which comprises a step of forming a conductive covering layer (13) at the bottom of the cavities (50) by physical vapour deposition.

3. Manufacturing method according to claim 2, wherein the step of forming a conductive covering layer (13) at the bottom of the cavities (50) comprises a physical deposition of metal in vapour form in a directional manner, along a direction parallel to the sidewalls of the cavities, and the physical deposition of metal in vapour form is adjusted so as to:
- exceed a percolation limit of the conductive covering layer (13) deposited at the bottom of the cavities (50), and
- not exceed the percolation limit of the conductive covering layer (13) deposited on the sidewalls of the cavities (50).

4. Manufacturing method according to either of claims 2 or 3, wherein the step of forming a conductive covering layer (13) at the bottom of the cavities (50) is adjusted so as to form, at the bottom of the cavities (50), a conductive covering layer (13) with a thickness comprised within a range of values from 2 nm to 15 nm, and preferably within a range of values from 3 nm to 10 nm.

5. Manufacturing method according to any one of claims 2 to 4, wherein the step of forming a conductive covering layer (13) at the bottom of the cavities (50) is provided so as to form, at the bottom of the cavities (50), a conductive covering layer (13) made of gold, or of platinum or of palladium or of silver or of copper.

6. Manufacturing method according to claim 5, wherein said adhesion sub-layer is formed beforehand, for example made of chromium, or titanium or tantalum.

7. Manufacturing method according to any one of claims 2 to 6, wherein the step of forming a conductive covering layer (13) at the bottom of the cavities (50) is carried out:
- under a vacuum level lower than 10⁻⁴ mbar, and preferably lower than 10⁻⁶ mbar,
- by placing, for example, a wafer of 150 mm in side or in diameter forming the substrate at least 500 mm from the source of material to be vaporised and preferably at least 700 mm from the source of material to be vaporised, and/or by heating the source of material to be vaporised just above its melting temperature,
- by using a metal source that is at least 99% pure, such as for example a gold source that is 99% pure by weight.

8. Manufacturing method according to any one of claims 1 to 7, comprising several iterations of steps b- to d- at least in order to form a mould with several layers of photosensitive resin (21), and wherein the step consisting in making at least part of the bottom of the cavities (50) conductive is carried out after at least a second iteration of steps b- and d- at least and preferably after all the iterations of steps b- and d- at least.

9. Manufacturing method according to any one of claims 1 to 8, wherein the photosensitive resin (21) is composed of epoxy resin, of propylene carbonate, of a triaryl-sulfonium initiator and of an organic solvent (cyclopentanone or gamma-butyrolactone), such as for example an SU-8 resin.

10. Manufacturing method according to any one of claims 1 to 9, wherein step a- comprises:
- an optional step consisting in depositing a sub-layer of chromium or of titanium or of tantalum and
- a step consisting in depositing a layer conducive to metal growth, such as a layer of gold or of copper or of palladium or of silver or of platinum on the substrate (10) in order to form the conductive surface.

11. Manufacturing method according to any one of claims 1 to 10, wherein steps a- to d- comprise at least:
- a heat treatment step, and/or
- a step of exposure to ultraviolet radiation, and/or
- a chemical treatment step such as an acid bath.

12. Method for manufacturing a metal part (41) by electrodeposition, comprising:
- the method for manufacturing a mould according to any one of claims 1 to 11,
- the manufacture of a metal part (41) in the mould by electrodeposition.

13. Method for manufacturing a metal part (41) according to claim 12, wherein the metal part (41) is a horological part.
